# EUROPEAN PATENT APPLICATION

(11) **EP 4 817 878 A1**
(43) Date of publication of application: **07.10.2026**
(21) Application number: 26168156.3
(22) Date of filing: 26.03.2026
(51) Int. Cl.: B41J 2/045, B41J 2/14, G02F 1/13, H10K 71/13

(54) **DRIVE WAVEFORM GENERATOR, LIQUID DISCHARGE HEAD, LIQUID DISCHARGE APPARATUS, MANUFACTURING APPARATUS FOR DISPLAY DEVICES, AND METHOD OF MANUFACTURING DISPLAY DEVICES**

(30) Priority: 02.04.2025 JP 2025060974; 13.03.2026 JP 2026040930
(71) Applicant: Ricoh Company, Ltd., Tokyo 143-8555 (JP)
(72) Inventor: YOSHIDA, Takahiro, Ohta-ku, 143-8555 (JP)
(74) Representative: J A Kemp LLP

(57) **Abstract**

A drive waveform generator and a method of manufacturing a display device with a color conversion layer are provided. The drive waveform generator includes a drive waveform generation unit configured to generate a drive waveform including a plurality of driving pulses to be applied to a liquid discharge head. The plurality of driving pulses include a discharge pulse to cause a liquid to be discharged, for liquid discharge of a first drop, and a combination of the discharge pulse and an excitation pulse not to cause the liquid to be discharged before the discharge pulse, for liquid discharge of a second drop. A landing position of the second drop is different from a landing position of the first drop. The method includes forming the color conversion layer by a liquid discharged from the liquid discharge head, and applying the drive waveform to the liquid discharge head.

## Description

### BACKGROUND

### Technical Field

The present disclosure relates to a drive waveform generator, a liquid discharge head, a liquid discharge apparatus, a manufacturing apparatus for display devices, and a method of manufacturing display devices.

### Background Art

Technologies to control discharge are disclosed, where the non-discharge period of every nozzle is obtained, and when there is a non-discharge period of a prescribed length of time, the size of the drop to be discharged in the initial discharging operation after such a non-discharge period has passed is increased (see, for example, Japanese Patent No. 4484293).

However, in technologies to control discharge in the related art, the size of the drop is changed after a non-discharge period has passed, and the transient response to the residual vibration, which is caused by changes from a non-discharge state to a discharging state and could affect the second drop, cannot be controlled. Accordingly, the landing position of the second drop is displaced, which is undesirable.

### SUMMARY

The present disclosure described herein provides a drive waveform generator and a method of manufacturing a display device with a color conversion layer. The drive waveform generator includes a drive waveform generation unit configured to generate a drive waveform including a plurality of driving pulses to be applied to a liquid discharge head. The plurality of driving pulses include a discharge pulse to cause a liquid to be discharged, for liquid discharge of a first drop, and a combination of the discharge pulse and an excitation pulse not to cause the liquid to be discharged before the discharge pulse, for liquid discharge of a second drop. A landing position of the second drop is different from a landing position of the first drop. The method includes forming the color conversion layer by a liquid discharged from the liquid discharge head, and applying the drive waveform to the liquid discharge head.

According to one aspect of the present disclosure, a reduction in the discharge speed of the second drop due to the transient response to the residual vibration of the first drop can be prevented, and a displacement in the landing position of the second drop can be prevented.

### BRIEF DESCRIPTION OF THE DRAWINGS

A more complete appreciation of embodiments and the many attendant advantages thereof will be readily obtained as the same becomes better understood by reference to the following detailed description when considered in connection with the accompanying drawings.
FIG. 1 is a schematic diagram of a printing apparatus according to a first embodiment.
FIG. 2 is a plan view of a discharge unit of a printing apparatus.
FIG. 3 is a cross-sectional view of a head taken in a direction perpendicular to a nozzle arrangement direction.
FIG. 4 is a cross-sectional view of a head in a nozzle arrangement direction.
FIG. 5 is a block diagram illustrating a functional configuration of a head drive controller and a head driver of a printing apparatus.
FIG. 6 is a graph illustrating the relation between discharge speed and frequency characteristics in continuous discharge according to a comparative example.
FIG. 7A and FIG. 7B are diagrams illustrating behavior from the first drop after a non-discharge period.
FIG. 8 is a diagram illustrating the discharge speed of the second drop due to the impact of residual vibration of the first drop.
FIG. 9 is a diagram illustrating a drive waveform in a discharge unit.
FIG. 10A, FIG. 10B, and FIG. 10C are diagrams each of which illustrates a drive waveform of a resonance cycle (natural-oscillation cycle) in a pressure chamber of a liquid discharge head.
FIG. 11 is a graph illustrating a time interval between an excitation pulse and a discharge pulse, indicated by N×Tc±(1/4)Tc, where Tc denotes a resonance cycle and N denotes a natural number.
FIG. 12 is a graph illustrating a time interval between an excitation pulse and a discharge pulse, indicated by N×Tc±(1/8)Tc, where Tc denotes a resonance cycle and N denotes a natural number.
FIG. 13A, FIG. 13B, and FIG. 13C are diagrams each of which illustrates a meniscus speed by simulation, which varies depending on a plurality of driving pulses.
FIG. 14 is a diagram illustrating a drive waveform in a discharge unit, according to a second embodiment.
FIG. 15 is a diagram illustrating a drive waveform in a discharge unit, according to a third embodiment.
FIG. 16 is a schematic diagram of a display device with organic light-emitting diodes (OLEDs), according to a fourth embodiment.
FIG. 17 is a sectional view of a display circuit board that serves as a color-conversion circuit board in a display device with organic light-emitting diodes (OLEDs), according to the fourth embodiment.
FIG. 18 is a perspective view of a manufacturing apparatus that manufactures a display device, according to a fourth embodiment.
FIG. 19 is a rear view of a first discharge device according to a fourth embodiment.
FIG. 20 is a diagram illustrating a method of manufacturing a display device and the order in which the display device is manufactured, according to a fourth embodiment.

The accompanying drawings are intended to depict embodiments of the present disclosure and should not be interpreted to limit the scope thereof. The accompanying drawings are not to be considered as drawn to scale unless explicitly noted. Also, identical or similar reference numerals designate identical or similar components throughout the several views.

### DETAILED DESCRIPTION

In describing embodiments illustrated in the drawings, specific terminology is employed for the sake of clarity. However, the present disclosure is not intended to be limited to the specific terminology so selected and it is to be understood that each specific element includes all technical equivalents that have the same structure, operate in a similar manner, and achieve a similar result.

Referring now to the drawings, embodiments of the present disclosure are described below. As used herein, the singular forms "a," "an," and "the" are intended to include the plural forms as well, unless the context clearly indicates otherwise.

A drive waveform generator, a liquid discharge head, a liquid discharge apparatus, a manufacturing apparatus for display devices, and a method of manufacturing display devices are described below in detail with reference to the drawings.

### First Embodiment

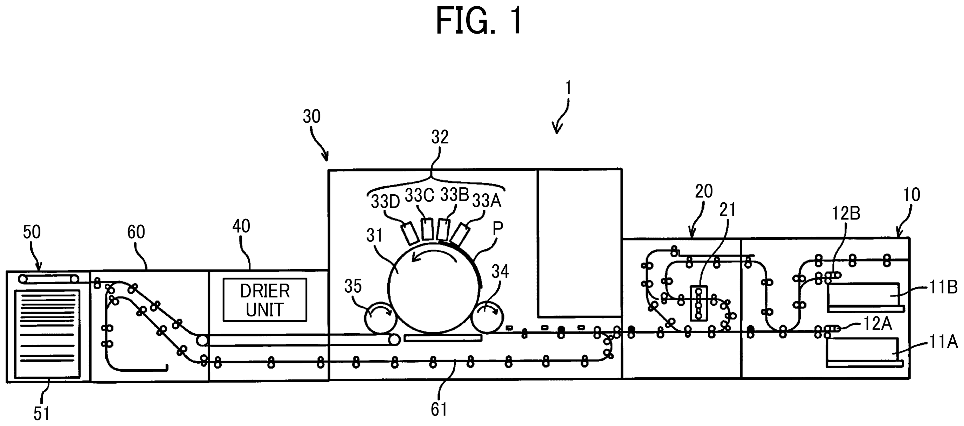

FIG. 1 is a schematic diagram of a printing apparatus 1 according to a first embodiment.

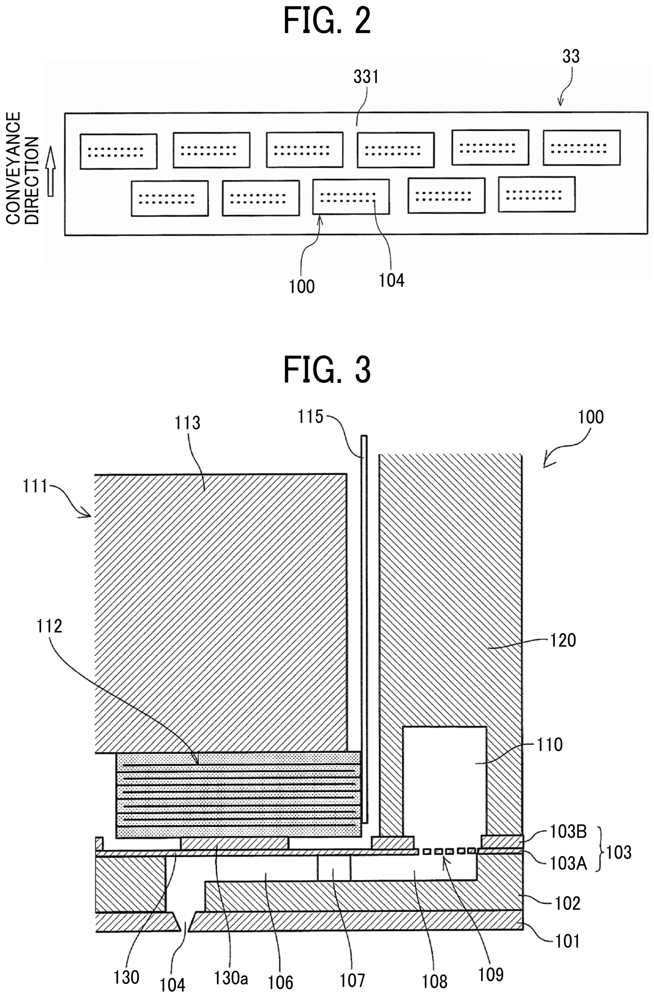

FIG. 2 is a plan view of a discharge unit 33 of the printing apparatus 1.

The printing apparatus 1 is a liquid discharge apparatus and a drive waveform generator, and includes a sheet loading unit 10 to convey a sheet P, a preprocessor 20, a printer unit 30, a dryer unit 40, and a sheet ejection unit 50. In the printing apparatus 1, the preprocessor 20 applies, if desired, a pretreatment liquid onto the sheet P loaded or supplied from the sheet loading unit 10, and the printing unit 30 applies the liquid to the sheet P to perform desired printing. Then, the dryer unit 40 dries the ink adhering to the sheet P, and the sheet P is ejected to the sheet ejection unit 50.

The sheet loading unit 10 is provided with a pair of sheet loading trays 11 including a lower sheet loading tray 11A and an upper sheet loading tray 11B to store a plurality of sheets P and a pair of feeders 12 including feeders 12A and 12B to feed the sheets P separately on a one-by-one basis from the sheet loading trays 11, and supplies the sheet P to the preprocessor 20.

The preprocessor 20 is provided with, for example, an applicator 21 that serves as a treatment-liquid applicator and applies treatment liquid, which has the effect of aggregating ink particles to prevent bleed-through, to the surface of the sheet P on which images are to be printed.

The printer unit 30 is provided with a drum 31 and a liquid discharge device 32. The drum 31 serves as a bearer or a rotator, and bears the sheet P on the peripheral surface and rotates. The liquid discharge device 32 discharges the liquid toward the sheet P borne on the drum 31.

The printer unit 30 is further provided with a transfer barrel 34 that receives the sheet P sent from the preprocessor 20 and passes the sheet P to the drum 31, and a transfer barrel 35 that receives the sheet P conveyed by the drum 31 and passes the sheet P to the dryer unit 40.

The transfer barrel 34 includes a sheet gripper, and that sheet gripper grips the front end of the sheet P conveyed from the preprocessor 20 to the printer unit 30. Then, the sheet P is conveyed as the transfer barrel 34 rotates. The transfer barrel 34 passes the conveyed sheet P to the drum 31 at a position facing the drum 31.

In a similar manner to the above, the drum 31 includes a sheet gripper on its surface, and the front end of the sheet P is gripped by the sheet gripper of the drum 31. A plurality of suction holes are formed on the surface of the drum 31 in a distributed manner, and a suction device generates a suction airflow directed inward from the desired ones of the suction holes of the drum 31.

The front end of the sheet P that is passed from the transfer barrel 34 to the drum 31 is gripped by the sheet gripper. Moreover, the sheet P is sucked up and borne onto the drum 31 by the suction airflow generated by the suction device, and is conveyed as the drum 31 rotates on the axis.

The liquid discharge device 32 includes discharge units 33 (i.e., discharge units 33A to 33D) to discharge liquids. For example, the discharge unit 33A discharges liquid of cyan (C), and the discharge unit 33B discharges liquid of magenta (M). Moreover, the discharge unit 33C discharges liquid of yellow (Y), and the discharge unit 33D discharges liquid of black (K). Further, the liquid discharge device 32 may adopt a discharge unit that discharges special liquid, that is, ink of spot color such as white, gold, or silver.

As illustrated in FIG. 2, for example, the discharge units 33 make up a full-line head in which a plurality of liquid discharge heads 100, each of which may be referred to simply as a head in the following description and has rows of nozzles where a plurality of nozzles 104 are arrayed, are arranged in a staggered manner on a base 331.

The discharging operation of each of the discharge units 33 of the liquid discharge device 32 is controlled by a driving signal that corresponds to print data. When the sheet P borne on the drum 31 passes through an area facing the liquid discharge device 32, multicolor liquids are discharged from the discharge units 33, and an image is formed on the sheet P according to the print data.

The dryer unit 40 dries the liquid adhered to the sheet P at the printer unit 30. As a result, liquid components such as moisture in the liquid evaporate, and the colorant that is contained in the liquid is fixed on the sheet P. Additionally, the sheet P is prevented from curling.

A reversing mechanism 60 reverses the sheet P in a switchback manner when duplex printing is to be performed on the sheet P that has passed through the dryer unit 40, and the reversed sheet P is fed back to a point upstream from the transfer barrel 34 through a conveyance path 61 in the printer unit 30.

The sheet ejection unit 50 is provided with an output tray 51 on which a plurality of sheets P are stacked. The sheets P that are conveyed through the reversing mechanism 60 from the dryer unit 40 are sequentially stacked and held on the output tray 51.

FIG. 3 is a cross-sectional view of the head 100 taken in a direction perpendicular to a nozzle arrangement direction.

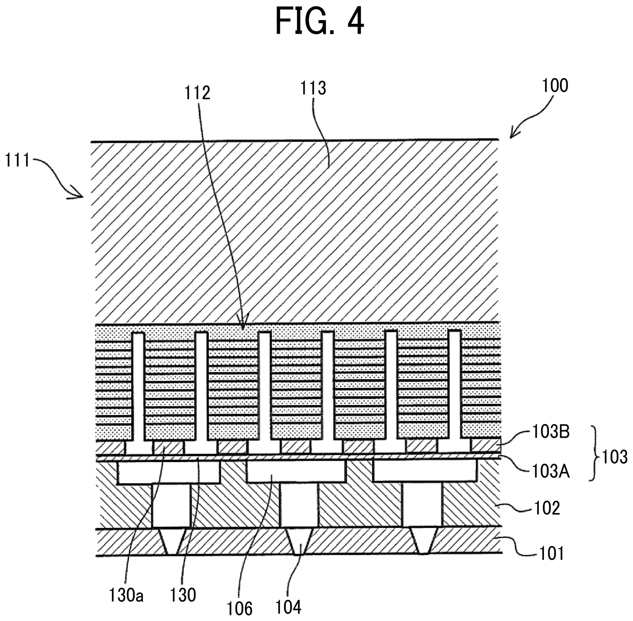

FIG. 4 is a cross-sectional view of the head 100 in a nozzle arrangement direction.

The liquid discharge head 100 has a nozzle plate 101, a channel substrate 102, and a vibration plate 103, and these elements are stacked on top of each other and bonded, where the channel substrate 102 serves as a separate pressure channel and the vibration plate 103 serves as a wall. The liquid discharge head 100 further includes a piezoelectric actuator 111 that displaces a vibration area 130 of the vibration plate 103 and a common channel 120 that also serves as the frame of the liquid discharge head 100.

The nozzle plate 101 has rows of nozzles where the nozzles 104 to discharge the liquid are arrayed.

The channel substrate 102 forms a plurality of pressure chambers 106 communicating with the nozzles 104, a plurality of selective supply channels 107 that serve as fluid restrictors and communicate with the pressure chambers 106, and an intermediate supply channel 108 that serves as a liquid introduction area and communicates with at least a pair of the selective supply channels 107.

The vibration plate 103 has a plurality of vibration areas 130 that make up the walls of the pressure chamber 106 of the channel substrate 102, and such areas are deformable and may be referred to as vibration plates in the following description. In the present embodiment, the vibration plate 103 has a two-layer structure (but not limited thereto), and includes a first layer 103A that makes up a thin portion and a second layer 103B that makes up a thick portion, which are arranged in the order listed with reference to the channel substrate 102.

The vibration areas 130 are formed in a deformable manner around the first layer 103A that is a thin-walled member, and those areas correspond to the areas of the pressure chambers 106. In the vibration areas 130, a convex portion 130a is formed that serves as a thick portion and is coupled to the piezoelectric actuator 111 in the second layer 103B.

The piezoelectric actuator 111 includes an electromechanical transducer that serves as, for example, a driver, an actuator, and a pressure generating element, and deforms the vibration areas 130 of the vibration plate 103, and is located on the other side of the pressure chamber 106 with respect to the vibration plate 103.

In the piezoelectric actuator 111, a piezoelectric member bonded on the base 113 is subjected to half-cut dicing to form grooves. Accordingly, a desired number of columnar piezoelectric elements 112 are formed at given intervals like a comb in the nozzle arrangement direction. The piezoelectric elements 112 are alternately bonded to a plurality of convex portions 130a, which are thick portions formed on the vibration area 130 of the vibration plate 103.

Each one of the piezoelectric elements 112 includes piezoelectric layers and internal electrodes that are alternately laminated in layers. The internal electrodes are separately led out to end faces and are coupled to an external electrode along the end faces, and the external electrodes are connected to a flexible wiring 115.

The common channel 120 forms a common supply channel 110. The common supply channel 110 communicates with the intermediate supply channel 108 that serves as a liquid introduction area through an opening 109 that is formed on the vibration plate 103 to serve as a filter portion, and communicates with the selective supply channel 107 through the intermediate supply channel 108.

In the liquid discharge head 100, for example, the voltage to be applied to the piezoelectric element 112 is lowered from a reference potential (intermediate potential) so that the piezoelectric element 112 contracts to pull the vibration area 130 of the vibration plate 103 to increase or expand the volume of the pressure chamber 106. As a result, liquid flows into the pressure chamber 106.

Then, the voltage to be applied to the piezoelectric element 112 is increased to expand the piezoelectric element 112 in the direction of lamination, and the vibration areas 130 of the vibration plate 103 are deformed in directions toward the nozzles 104 to reduce the volume of the pressure chamber 106. As a result, the liquid in the pressure chamber 106 is pressurized and discharged from the nozzle 104.

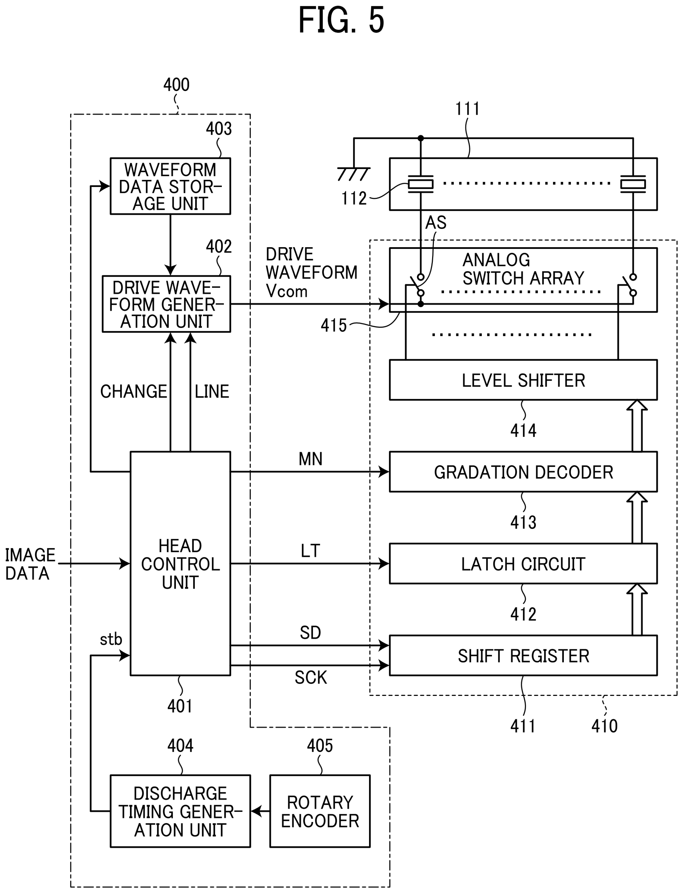

FIG. 5 is a block diagram illustrating a functional configuration of a head drive controller 400 and a head driver 410 of the printing apparatus 1.

The head drive controller 400 that gives a drive waveform to the head 100 serves as a drive waveform generator. The head drive controller 400 includes a head control unit 401, a drive waveform generation unit 402, a waveform data storage unit 403, the head driver 410, a discharge timing generation unit 404 that generates a discharge timing, and a rotary encoder 405.

Upon receiving a discharge timing pulse stb, the head control unit 401 outputs a discharge synchronizing signal LINE to the drive waveform generation unit 402, which triggers the generation of a drive waveform. The head control unit 401 outputs a discharge timing signal CHANGE corresponding to a degree of delay from the discharge synchronizing signal LINE, to the drive waveform generation unit 402.

The drive waveform generation unit 402 generates a common drive waveform Vcom at the timing based on the discharge synchronizing signal LINE and the discharge timing signal CHANGE.

The head control unit 401 receives image data and generates a mask control signal MN based on the image data. The mask control signal MN is used to select the predetermined waveform of the common drive waveform signal Vcom according to the volume of the liquid droplet to be discharged from each nozzle 104 of the head 100. The mask control signal MN is a signal indicating a time synchronized with the discharge timing signal CHANGE.

The head control unit 401 transfers image data SD, a synchronization clock signal SCK, a latch signal LT specifying the latch of the image data, and the generated mask control signal MN to the head driver 410.

The head driver 410 includes a shift register 411, a latch circuit 412, a gradation decoder 413, a level shifter 414, and an analog switch array 415.

The shift register 411 receives the image data SD and the synchronization clock signal SCK transferred from the head control unit 401. The latch circuit 412 latches each register value on the shift register 411 according to the latch signal LT transferred from the head control unit 401.

The gradation decoder 413 decodes the value (image data SD) latched by the latch circuit 412 and the mask control signal MN and outputs the result of decoding. The level shifter 414 converts the level of a logic-level voltage signal of the gradation decoder 413 to a level operable by the analog switch AS of the analog switch array 415.

The analog switch AS of the analog switch array 415 is a switch that is turned on and off by the output from the gradation decoder 413 through the level shifter 414. The analog switch AS is provided for each nozzle 104 of the head 100 and is connected to an individual electrode of the piezoelectric element 112 corresponding to each nozzle 104. The common drive waveform signal Vcom from the drive waveform generation unit 402 is input to the analog switch AS. As described above, the timing of the mask control signal MN is synchronized with the timing of the common drive waveform Vcom.

Accordingly, the analog switch AS is switched between on and off in a timely manner in accordance with the output from the gradation decoder 413 given through the level shifter 414, and the driving pulse to be applied to the piezoelectric element 112 corresponding to each nozzle 104 is selected from the driving pulses that make up the common drive waveform signal Vcom. As a result, the volume of the droplets that are discharged from the nozzle 104 is controlled as desired.

The discharge timing generation unit 404 generates and outputs the discharge timing pulse stb every time the sheet P is conveyed by a predetermined amount, based on the detection results of the rotary encoder 405 that detects the revolutions per minute (rpm) of the drum 31. The rotary encoder 405 includes an encoder wheel that rotates with the drum 31 and an encoder sensor that reads the slits of the encoder wheel.

Technologies to control discharge in an inkjet head according to a comparative example are described below.

In technologies to control discharge according to a comparative example, the size of the first drop is increased in view of dried nozzles, and variations in landing position due to the thickening caused by drying are reduced accordingly. Moreover, in technologies to control discharge according to a comparative example, the discharge speed of the first drop is made higher by the residual vibration of the microdrive waveform in the previous cycle before the first drop, or the discharge speed of the first drop is made slower to meet the discharge speed when the head 100 is driven at high frequencies.

In parallel with that, a transient response to a residual vibration may take place when an inkjet head starts discharging a liquid after a non-discharge period. This is a residual vibration of an ink supplying operation, which may be referred to as a vibration of an ink refilling operation, and is a characteristic that affects only a few drops after the first drop. The length of the non-discharge period is, for example, 5 microseconds (µs) after the head discharges ink droplets. The length of time after the head discharges ink droplets may be 10 µs or 15 µs, which is longer than 5 µs.

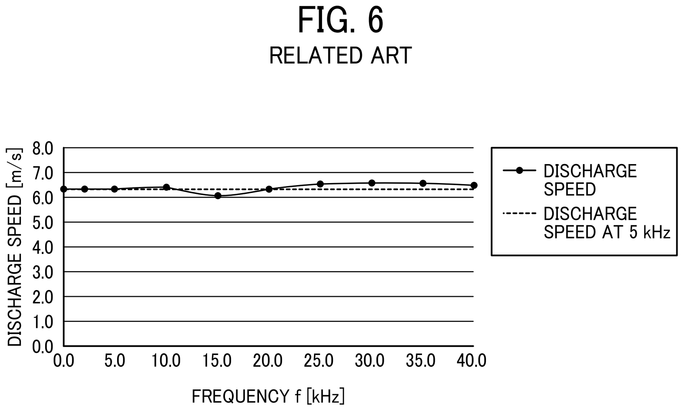

FIG. 6 is a graph illustrating the relation between discharge speed and frequency characteristics in continuous discharge according to a comparative example.

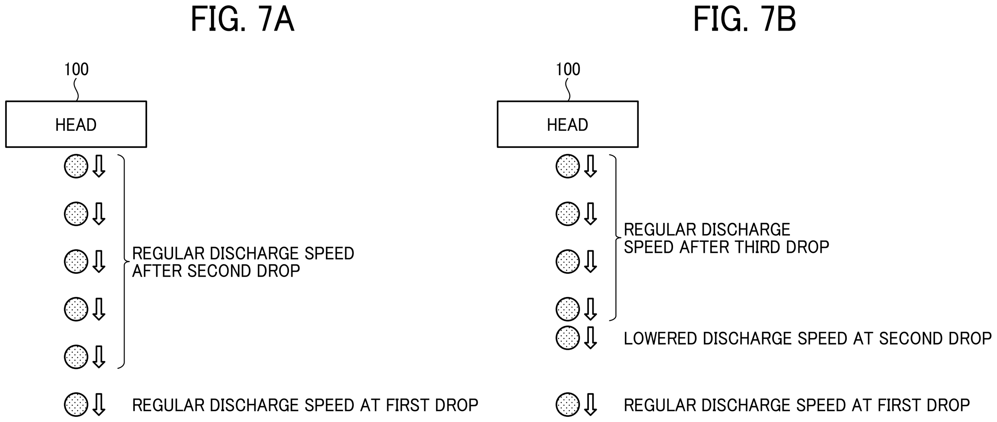

FIG. 7A and FIG. 7B are diagrams illustrating behavior from the first drop after a non-discharge period.

FIG. 7A illustrates behavior as desired, and FIG. 7B illustrates behavior according to a comparative example.

In FIG. 6, a typically-obtained result of the evaluation of discharge speeds where the drive frequency is a variable is illustrated. When the head 100 is driven at low frequencies such as 5 kilohertz (kHz) in FIG. 6, where the discharge interval on a pixel-by-pixel basis is 200 µs, a sufficiently long time has passed after the previously-discharged drop, and the impact of residual vibration of the previously-discharged drop is almost none. For this reason, the discharge speed under such conditions becomes a basis for analysis in the graph of FIG. 6. In the graph of FIG. 6, even when the drive frequency is increased to 40 kHz, changes in discharge speed are very little, and the degree of stability is sufficiently high.

However, as illustrated in FIG. 7A and FIG. 7B, the discharging behavior in a comparative example is observed from the first drop after a non-discharge period, and it is understood that the discharge speed of the second drop decreases.

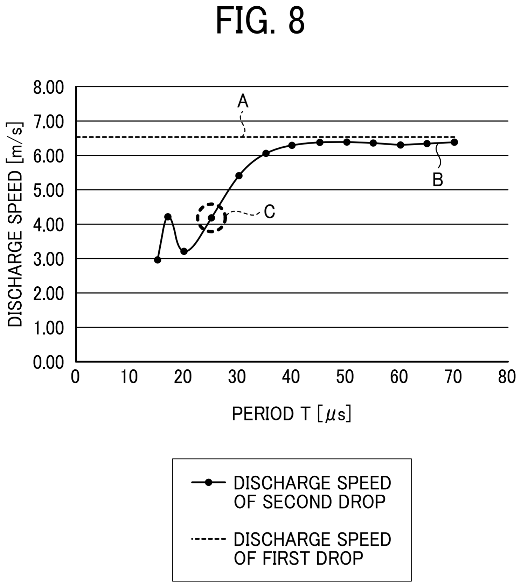

FIG. 8 is a diagram illustrating the discharge speed of the second drop due to the impact of residual vibration of the first drop.

The evaluation of the discharge speed of the second drop when the drive frequency (or drive cycle) is changed yielded results as illustrated in FIG. 8. In FIG. 8, a line A indicates the discharge speed of the first drop, and a line B indicates the discharge speed of the second drop. Moreover, a circle C on the line B indicates an area that indicates a cycle of 25 µs that corresponds to 40 kHz, which is the maximum frequency in the graph of FIG. 6.

When the cycle is equal to or longer than 40 µs and the drive frequency is low, the discharge speed of the first drop is almost equal to the discharge speed of the second drop. By contrast, when the cycle is short and the drive frequency is high, the discharge speed of the second drop is low. In view of the fact that the discharge speed gradually decreases as the cycle gets shorter than a cycle of 40 µs, it is understood that the impact of a natural period of a short cycle is small, but the impact of a long period is strong. In other words, the residual vibration of an ink supplying operation (i.e., the oscillation caused by refilling) is strong. It appears that the discharge speed increases around cycles of 17 µs due to the impact of a natural period. However, in its entirety, the impact of the oscillation caused by refilling is strong.

A reduction in the discharge speed of the second drop, which is caused by changes from a non-discharge state to a discharging state, as described above, cannot be addressed by technologies to control discharge according to a comparative example.

In order to handle such a situation, in the present embodiment, when the head 100 is continuously driven with discharge pulses, a waveform with excitation pulse and discharge pulse is adopted for the second drop. Due to such a configuration, a reduction in the discharge speed of the second drop due to the impact of residual vibration of the first drop can be prevented. This point will be described later in detail.

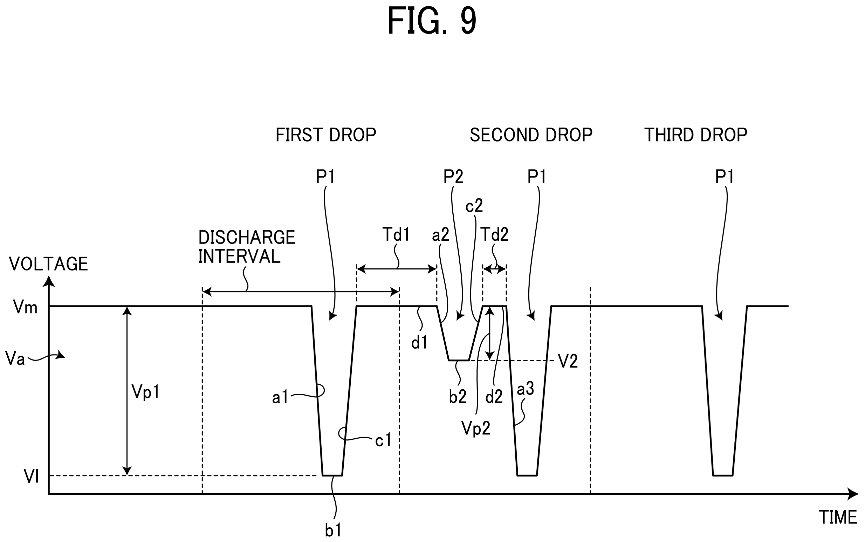

FIG. 9 is a diagram illustrating a drive waveform Va in a discharge unit 33.

As illustrated in FIG. 9, in a drive waveform Va according to the present embodiment where the head 100 is continuously driven with discharge pulses, a waveform where excitation pulse P2 and discharge pulse P1 are combined is adopted only for the second drop after the first drop is discharged with discharge pulse P1. The landing position of the second drop of liquid is different from the landing position of the first drop of liquid.

As illustrated in FIG. 9, the drive waveform Va includes, as a plurality of driving pulses after a non-discharge period is changed to a discharge period, discharge pulse P1 and excitation pulse P2, discharge pulse P1, and discharge pulse P1, continuously and chronologically in the order listed. In other words, the discharge pulse to cause the liquid to be discharged as the driving pulse for the liquid discharge of the first drop has a waveform equivalent to that of the discharge pulse to cause the liquid to be discharged as the driving pulse for the liquid discharge of the second drop.

The discharge pulse P1 is a discharge pulse that applies pressure to the liquid in the pressure chamber 106 to cause the liquid to be discharged. The discharge pulse P1 is composed of, for example, an expansion waveform a1 with which the pressure chamber 106 is expanded, a keeping waveform b1 with which the pressure chamber 106 expanded with the expansion waveform a1 is kept expanded, and a contraction waveform c1 with which the pressure chamber 106 that is kept expanded by the keeping waveform b1 is contracted to discharge the liquid.

The expansion waveform a1 of the discharge pulse P1 is a waveform that falls from the intermediate potential (or reference potential) Vm to the potential V1, and the keeping waveform b1 is a waveform to keep the potential V1. The contraction waveform c1 is a waveform that rises from the potential V1 to the intermediate potential Vm. It is assumed that the peak value of this discharge pulse P1 is Vp1.

The excitation pulse P2 is a non-discharge pulse that can be used as a microdrive waveform with which the liquid inside the pressure chamber 106 is pressurized to a certain degree that the liquid is not discharged but the meniscus is vibrated. The excitation pulse P2 is composed of, for example, an expansion waveform a2 with which the pressure chamber 106 is expanded, a keeping waveform b2 with which the pressure chamber 106 expanded with the expansion waveform a2 is kept expanded, and a contraction waveform c2 with which the pressure chamber 106 that is kept expanded by the keeping waveform b2 is contracted to vibrate the meniscus.

The expansion waveform a2 of the excitation pulse P2 is a waveform that falls from the intermediate potential (or reference potential) Vm to the potential V2, where V2 is smaller than V1, and the keeping waveform b2 is a waveform to keep the potential V2. The contraction waveform c2 is a waveform that rises from the potential V2 to the intermediate potential Vm. It is assumed that the peak value of this excitation pulse P2 is Vp2.

The waveform from the endpoint of the contraction waveform c1 of the discharge pulse P1 for the first drop to the start point of the expansion waveform a2 of the excitation pulse P2 is referred to as an inter-pulse keeping waveform d1, and the length of time of the inter-pulse keeping waveform d1, which is the time interval between discharge pulse P1 and excitation pulse P2, is referred to as Td1.

The waveform from the endpoint of the contraction waveform c2 of excitation pulse P2 to the start point of the expansion waveform a3 of discharge pulse P1 for the second drop is referred to as an inter-pulse keeping waveform d2, and the length of time of the inter-pulse keeping waveform d2, which is the time interval between excitation pulse P2 and discharge pulse P1, is referred to as Td2.

The time interval Td2 between the excitation pulse P2 and the discharge pulse P1 of the second drop is in a resonant relation. When in such a resonant relation, the pressing force when the liquid inside the pressure chamber 106 is pressurized with discharge pulse P1 for the second drop is amplified due to the residual vibration when the liquid inside the pressure chamber 106 is pressurized with excitation pulse P2.

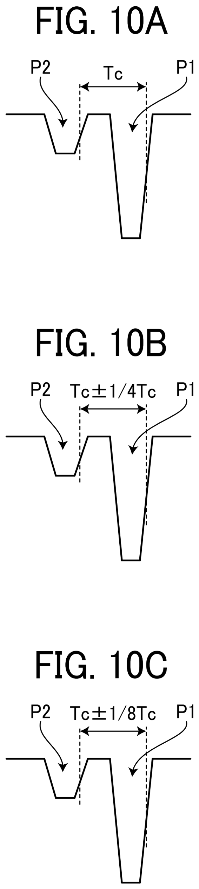

FIG. 10A, FIG. 10B, and FIG. 10C are diagrams each of which illustrates a drive waveform of a resonance cycle Tc (natural-oscillation cycle) in the pressure chamber 106 of the liquid discharge head 100.

FIG. 10A is a diagram illustrating a drive waveform where a resonance cycle (natural-oscillation cycle) Tc is the time difference between the time during which the voltage of the excitation pulse P2 changes and the time during which the voltage of the discharge pulse P1 of the second drop changes.

FIG. 10B is a diagram illustrating a drive waveform where a resonance cycle (natural-oscillation cycle) Tc±(1/4)Tc is the time difference between the time during which the voltage of the excitation pulse P2 changes and the time during which the voltage of the discharge pulse P1 of the second drop changes.

FIG. 10C is a diagram illustrating a drive waveform where a resonance cycle (natural-oscillation cycle) Tc±(1/8)Tc is the time difference between the time during which the voltage of the excitation pulse P2 changes and the time during which the voltage of the discharge pulse P1 of the second drop changes.

In the present embodiment, it is desired that the time interval Td2 between the excitation pulse P2 and the discharge pulse P1 of the second drop be within the range of N×Tc-(1/4)Tc to N×Tc+(1/4)Tc, where Tc denotes a resonance cycle (natural-oscillation cycle) in the pressure chamber 106 of the liquid discharge head 100 and N denotes a natural number.

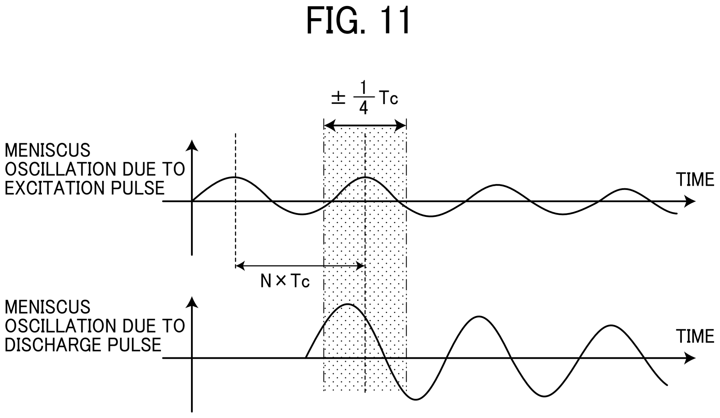

FIG. 11 is a graph illustrating a time interval between an excitation pulse and a discharge pulse, indicated by N×Tc±(1/4)Tc, where Tc denotes a resonance cycle and N denotes a natural number.

Furthermore, it is desired that such a time interval between an excitation pulse and a discharge pulse be within the range of N×Tc-(1/8)Tc to N×Tc+(1/8)Tc, where N denotes a natural number.

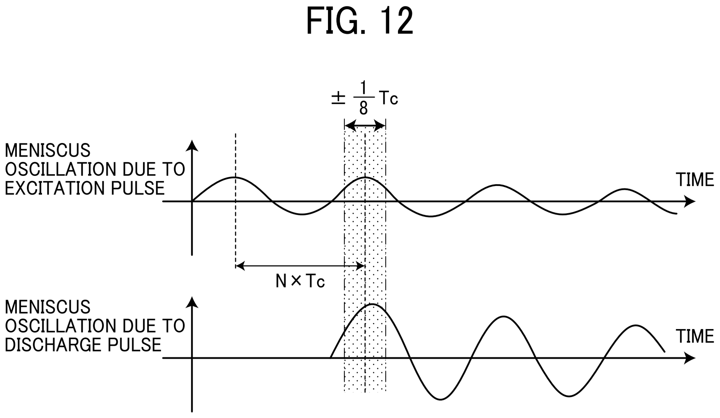

FIG. 12 is a graph illustrating a time interval between an excitation pulse and a discharge pulse, indicated by N×Tc±(1/8)Tc, where Tc denotes a resonance cycle and N denotes a natural number.

Due to such configurations as described above, the discharge speed of the second drop is to be discharged with discharge pulse P1 can be increased by the residual vibration caused by excitation pulse P2. Furthermore, residual vibrations can be utilized more efficiently in an area indicated by N×Tc±(1/8)Tc, and the influence of variations in the natural period of the head 100 can be reduced.

Some aspects of the present disclosure will be described below in detail.

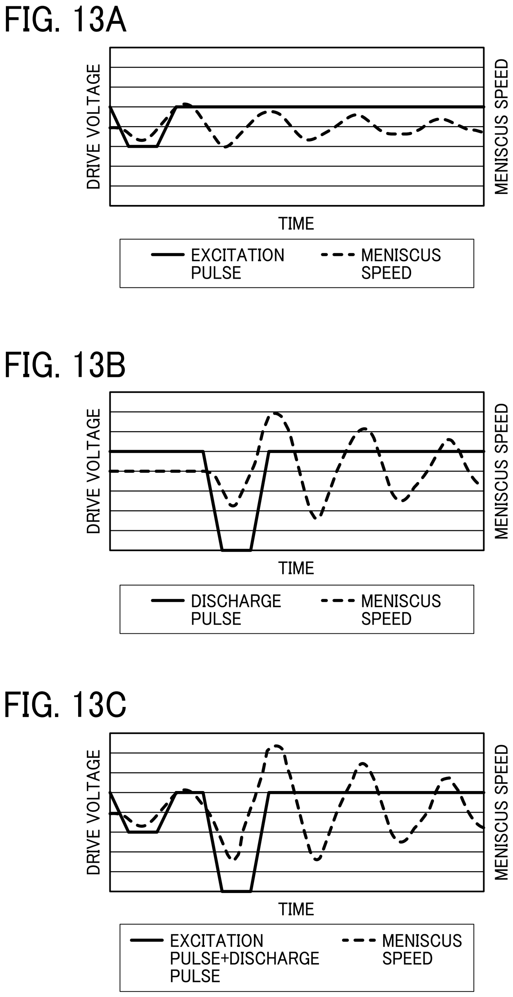

FIG. 13A, FIG. 13B, and FIG. 13C are diagrams each of which illustrates a meniscus speed by simulation, which varies depending on a plurality of driving pulses.

FIG. 13A illustrates a meniscus speed by excitation pulses P2, and FIG. 13B illustrates a meniscus speed by discharge pulses P1. FIG. 13C illustrates a meniscus speed by a combination of excitation pulse P2 and discharge pulses P1.

FIG. 13C indicates that an interval between excitation pulse P2 and discharge pulse P1 is in a resonant relationship, and that interval indicates a resonance cycle Tc. As illustrated in FIG. 13C, by inserting excitation pulse P2 before discharge pulse P1, the meniscus speed increases compared with the case of FIG. 13B with discharge pulses P1 only. In other words, the discharge speed increases.

As described above, according to the present embodiment, even when the discharge speed of the second drop is low due to the residual vibration of the first drop, the second drop can be discharged at a discharge speed higher than the discharge speed when the second drop is discharged with a discharge pulse alone, and the second drop can be continuously discharged at a discharge speed equivalent to or close to the discharge speed for the first drop. Accordingly, a reduction in the discharge speed of the second drop due to the transient response to the residual vibration of the first drop can be prevented, and a displacement in the landing position of the second drop can be prevented. Moreover, an image of high quality can be formed.

In view of the fact that the landing of the second drop is not delayed when the drive cycle is long, in a high-resolution mode where the head 100 is driven at low frequencies and the pulse interval between the first drop and the second drop is distant, the impact of residual vibration of the first drop is so little that the discharge speed of the second drop does not decrease easily. For this reason, the present embodiment is not to be applied to a high-resolution mode where the head 100 is driven at low frequencies, and it is desired that the present embodiment be applied to a high-productivity mode where the head 100 is driven at high frequencies. In view of the above circumstances, it is not necessary to limit the pulse interval between an excitation pulse and a discharge pulse in a high-resolution mode to a resonant timing. Accordingly, the design flexibility of a drive waveform for a high-resolution mode increases, enabling the design of a drive waveform dedicated to high resolution.

### Second Embodiment

The second embodiment is different from the first embodiment in the respect that an excitation pulse is added to the third drop and the following drops. In the following description of the second embodiment, descriptions of elements identical or similar to those in the first embodiment are omitted, and differences from the first embodiment are described.

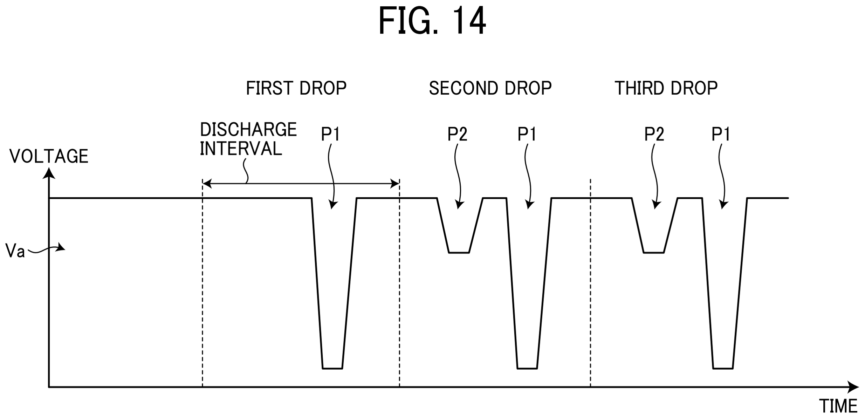

FIG. 14 is a diagram illustrating a drive waveform Va in the discharge unit 33, according to a second embodiment.

FIG. 14 is a diagram illustrating the drive waveform Va where the waveform of excitation pulse P2 and discharge pulse P1 are applied to the driving pulses of the second drop and the third drop.

As illustrated in FIG. 14, the drive waveform Va includes, as a plurality of driving pulses after a non-discharge period is changed to a discharge period, discharge pulse P1, excitation pulse P2 and discharge pulse P1, and excitation pulse P2 and discharge pulse P1, continuously and chronologically in the order listed.

As described above, according to the present embodiment, when the discharge speed is reduced after the third drop, that discharge speed can be increased again. Due to such a configuration, the effect of excitation is applied to all the droplets whose discharge speed is reduced after the second drop, and a reduction in the discharge speed due to the transient response to the discharge of the first drop can be prevented. Accordingly, the liquid can be stably discharged.

When the head 100 is continuously driven to discharge three or more drops of liquid with discharge pulses P1 and the impact of the residual vibration of the first drop extends to the third drop and the following drops, the waveform of excitation pulse P2 and discharge pulse P1 may be applied to the driving pulses of the second drop and the third drop and the following drops. In other words, excitation pulse P2 may be added or applied not only to the second drop but also to the third drop and the following drops.

### Third Embodiment

The third embodiment is different from the first embodiment and the second embodiment of the present disclosure as described above in a respect that excitation pulses are used as microdrive pulses with which droplets are not discharged in a non-printing area. In the following description of the third embodiment, descriptions of elements identical or similar to those in the first embodiment or the second embodiment are omitted, and differences from the first embodiment and the second embodiment are described.

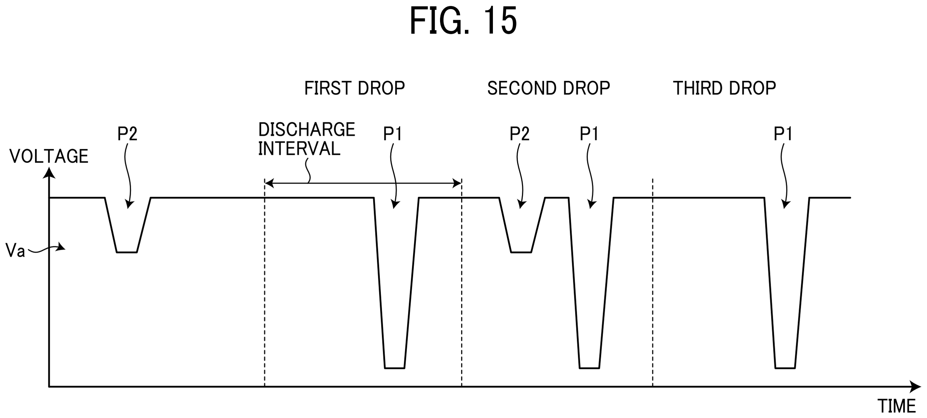

FIG. 15 is a diagram illustrating a drive waveform in the discharge unit 33, according to a third embodiment.

More specifically, FIG. 15 illustrates a drive waveform where excitation pulses P2 are used as microdrive pulses with which droplets are not discharged in a non-printing area.

As illustrated in FIG. 15, the drive waveform Va includes, as a plurality of driving pulses when a non-discharge period is changed to a discharge period, excitation pulse P2, discharge pulse P1, excitation pulse P2 and discharge pulse P1, and discharge pulse P1 continuously and chronologically in the order listed.

In the present embodiment described with reference to FIG. 15, excitation pulses P2 are used as microdrive pulses with which droplets are not discharged in a non-printing area. In such cases, excitation pulse P2 is used to prevent the meniscus in a non-printing area from being dried. Due to such a configuration, a microdrive pulse applied to a non-printing area can be shared with the excitation pulse P2 used to excite the second drop. Accordingly, the length of the drive waveform can be shortened, and the head 100 can be driven at high frequencies.

In the present disclosure, the liquid discharge apparatus includes a liquid discharge head or a liquid discharge unit, and drives the liquid discharge head to discharge liquid. The liquid discharge apparatus includes not only an apparatus that discharges liquid to an object to which liquid adheres but also an apparatus that discharges liquid into liquid or the air.

The liquid discharge apparatus may include means for feeding, conveying, or ejecting an object to which liquid adheres, or may include, for example, a pretreatment device and a post-processing apparatus.

The liquid discharge apparatus may be, for example, an image forming apparatus to form an image on a sheet by discharging ink, or a three-dimensional object forming apparatus to discharge molding liquid to a powder layer in which powder material is formed in layers, so as to form a three-dimensional object.

The liquid discharge apparatus is not limited to an apparatus that uses the discharged liquid to visualize images with some meaning such as letters or figures. For example, the liquid discharge apparatus may be an apparatus that forms meaningless images such as meaningless patterns or an apparatus that fabricates three-dimensional images.

The term "object to which liquid adheres" as above denotes, for example, an object to which liquid can at least temporarily adhere, an object to which liquid adheres and is fixed, and an object to which liquid adheres and permeates. Concrete examples of the "object to which liquid adheres" include, but are not limited to, a recording medium such as a sheet of paper, recording sheet, a recording sheet of paper, a film, or cloth, an electronic component such as an electronic substrate or a piezoelectric element, and a medium such as powder layer, an organ model, or a cell for testing. The "object to which liquid adheres" includes any medium to which liquid adheres, unless otherwise specified.

Examples of the object to which liquid can adhere are satisfactory as long as they are any materials to which liquid can adhere even temporarily, such as paper, thread, fiber, fabric, leather, metal, plastic, glass, wood, and ceramic.

The term "liquid" may be any substance as long as it has viscosity or surface tension and can be discharged through the head, and is not limited to any particular liquid. It is desired that the viscosity of the liquid be equal to or lower than 30 millipascal-second (mPa·s) under normal temperature and normal atmospheric pressure or by heating or cooling. More specifically, examples of the liquid to be discharged include, for example, a solution, a suspension, and an emulsion, and those examples include, for example, solvents such as water and organic solvents, colorants such as dyes and pigments, high-performance materials or functional materials such as polymerized compounds, resin, surfactants, biomaterials such as deoxyribonucleic acid (DNA), amino acids, proteins, and calcium, and edible materials such as a natural colorants. Such a solution, a suspension, or an emulsion are used for, for example, ink for inkjet printing, surface treatment liquid, a liquid for forming components of an electronic element or light-emitting element, a liquid for forming a resist pattern of an electronic circuit, and a material liquid used to form a three-dimensional object.

Examples of the liquid discharge apparatus further include a treatment liquid applicator to discharge a treatment liquid to a sheet to coat the treatment liquid on a sheet surface to reform the sheet surface and an injection granulation system in which a composition liquid including raw materials dispersed in a solution is discharged through nozzles to granulate fine particles of the raw materials.

The terms "image formation," "recording," "printing," "image printing," and "fabricating" used herein can be used synonymously with each other.

### Fourth Embodiment

The liquid discharge head 100 provided with the drive waveform generator or a liquid discharge apparatus for the printing apparatus 1 can be applied to a manufacturing apparatus for manufacturing a display circuit board that serves as a color-conversion circuit board in a display device with organic light-emitting diodes (OLEDs). In other words, the liquid discharge head 100 provided with the drive waveform generator or a liquid discharge apparatus for the printing apparatus 1 can be applied to a manufacturing apparatus for manufacturing display devices. The configuration or structure of the display circuit board that serves as a color-conversion circuit board and the manufacturing apparatus for manufacturing color-conversion circuit boards are described below.

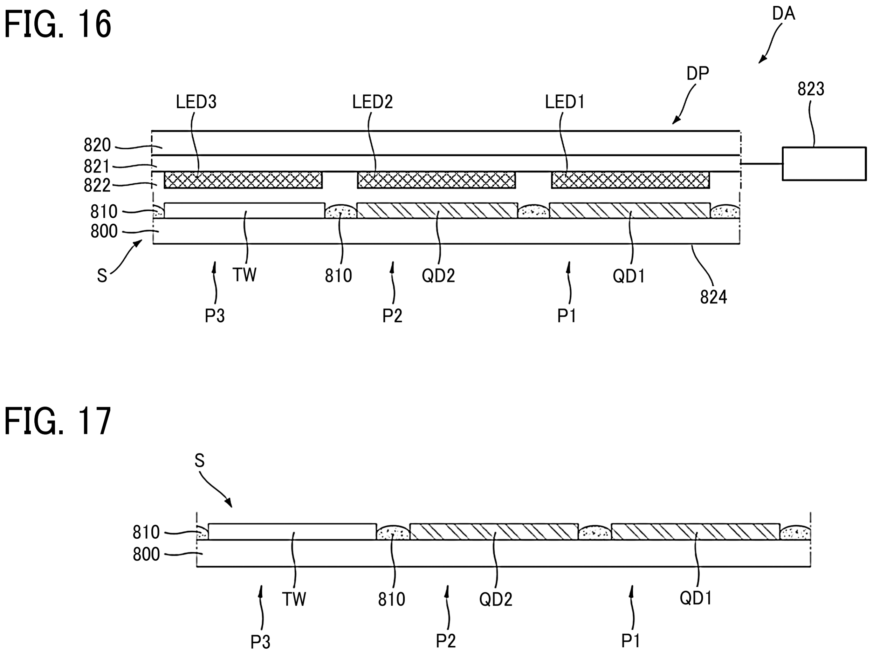

FIG. 16 is a schematic diagram of a display device DA with organic light-emitting diodes (OLEDs), according to a fourth embodiment.

The display device DA includes an organic light-emitting diode (OLED) panel DP and a controller 823 that controls the operation of the OLED panel DP. The OLED panel DP includes a backplane circuit board 820 that serves as a base material of the OLED panel, a thin-film transistor (TFT) layer 821 that is formed on the downside of the backplane circuit board 820, and an intermediate layer 822 that couples the TFT layer 821 to the display circuit board S.

On the TFT layer 821, light-emitting layers LED1, LED2, and LED3 are formed so as to correspond to the pixels P1, P2, and P3 of the OLED panel DP, respectively. The TFT layer 821 further includes a thin-film transistor (TFT) that controls the power supply to the light-emitting layers LED1 to LED3. The TFT layer 821 is coupled to the controller 823, and controls the power to be supplied to the light-emitting layers LED1 to LED3 under the control of the controller 823 on a one-by-one basis.

The display circuit board S has a first color conversion layer QD1 and a second color conversion layer QD2 on the topside of the substrate 800 so as to correspond to the pixels P1 and P2. Each of the first color conversion layer QD1 and the second color conversion layer QD2 converts the color of the light emitted from the light-emitting layer LED1 and the light-emitting layer LED2, and emits the converted light toward a lower surface 824 of the substrate 800.

The controller 823 controls the TFT layer 821 that corresponds to the pixels P1 to P3 so as to control the time and radiation intensity of the light emitted from the light-emitting layers LED1 to LED3 that correspond to the pixels P1 to P3. Accordingly, the light that is emitted from the lower surface 824 of the substrate 800 can be controlled, and an image can be formed as desired on the lower surface 824 of the substrate 800.

FIG. 17 is a sectional view of the display circuit board S that serves as a color-conversion circuit board in the display device DA with organic light-emitting diodes (OLEDs), according to the fourth embodiment.

The display circuit board S may include the substrate 800, and the first color conversion layer QD1, the second color conversion layer QD2, a transmissive layer TW, and light-blocking patterns 810, which are arranged on the substrate 800. In such a configuration, the first color conversion layer QD1, the second color conversion layer QD2, and the transmissive layer TW may form one light-emitting area.

The first color conversion layer QD1 and the second color conversion layer QD2 are layers that transmit or express (e.g., clearly express) the color of the light emitted from a light-emitting element adjacent to the display circuit board S or convert a color into another color. Each of the first color conversion layer QD1 and the second color conversion layer QD2 may include quantum dots, and may include a quantum conversion layer. A quantum dot is a semiconductor particle having a diameter of 2 nanometers (nm) to 10 nm and having unusual electrical and optical properties. When a quantum dot is exposed to light, the quantum dot may emit light of a specific frequency according to, for example, its particle size and the type of material. For example, when a quantum dot is exposed to light, the quantum dot may emit red light, green light, or blue light according to the particle size and/or the type of material.

A core of a quantum dot may be selected from among a group II-VI compound, a group III-V compound, a group IV-VI compound, a group IV element, a group IV compound, and a combination thereof.

The group II-VI compound may be selected from among a binary compound selected from the group consisting of CdSe, CdTe, ZnS, ZnSe, ZnTe, ZnO, HgS, HgSe, HgTe, MgSe, MgS, and a mixture thereof; a ternary compound selected from the group consisting of AgInS, CuInS, CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, MgZnS, and a mixture thereof; and a quaternary compound selected from the group consisting of HgZnTeS, CdZnSeS, CdZnSeTe, CdZnSTe, CdHgSeS, CdHgSeTe, CdHgSTe, HgZnSeS, HgZnSeTe, HgZnSTe, and a mixture thereof.

The group III-V compound may be selected from among a binary compound selected from the group consisting of GaN, GaP, GaAs, GaSb, AIN, AlP, AlAs, AlSb, InN, InP, InAs, InSb, and a mixture thereof; a ternary compound selected from the group consisting of GaNP, GaNAs, GaNSb, GaPAs, GaPSb, AlNP, AlNAs, AlNSb, AlPAs, AlPSb, InGaP, InNP, InNAs, InNSb, InPAs, InPSb, GaAlNP, and a mixture thereof; and a quaternary compound selected from the group consisting of GaAlNAs, GaAlNSb, GaAlPAs, GaAlPSb, GaInNP, GaInNAs, GaInNSb, GaInPAs, GaInPSb, InAlNP, InAlNAs, InAlNSb, InAlPAs, InAlPSb, and a mixture thereof.

The group IV-VI compound may be selected from among a binary compound selected from the group consisting of SnS, SnSe, SnTe, PbS, PbSe, PbTe, and a mixture thereof; a ternary compound selected from the group consisting of SnSeS, SnSeTe, SnSTe, PbSeS, PbSeTe, PbSTe, SnPbS, SnPbSe, SnPbTe, and a mixture thereof; and a quaternary compound selected from the group consisting of SnPbSSe, SnPbSeTe, SnPbSTe, and a mixture thereof. The group IV element may be selected from the group consisting of silicon (Si), germanium (Ge), and a mixture thereof. The group IV compound may be a binary compound selected from the group consisting of SiC, SiGe, and a mixture thereof.

In such cases, the binary compound, the ternary compound, or the quaternary compound may exist in particles at a uniform concentration, or may exist in the same particle divided into two states where the distribution of concentration is partially different. The quantum dot may have a core/shell structure in which one quantum dot surrounds another quantum dot. An interface between the core and the shell may have a concentration gradient in which the concentration of an element in the shell gradually decreases toward the center.

In some embodiments, a quantum dot may have a core-shell structure including a core including a nanocrystal and a shell surrounding the core. The shell of the quantum dot may function as a protective layer for maintaining semiconductor characteristics by preventing or reducing chemical denaturation of the core and/or a charging layer for giving electrophoretic characteristics to the quantum dot. The shell may have a single-layer or multi-layer structure. An interface between the core and the shell may have a concentration gradient in which the concentration of an element in the shell gradually decreases toward the center. Examples of the shell of the quantum dot may include an oxide of a metal or a nonmetal, a semiconductor compound, and a combination thereof.

Examples of the oxide of the metal or the nonmetal may include, but are not limited to, a binary compound such as SiO₂, Al₂O₃, TiO₂, ZnO, MnO, Mn₂O₃, Mn₃O₄, CuO, FeO, Fe₂O₃, Fe₃O₄, CoO, Co₃O₄, or NiO and a ternary compound such as MgAl₂O₄, CoFe₂O₄, NiFe₂O₄, or CoMn₂O₄.

Examples of the semiconductor compound may include, but are not limited to, CdS, CdSe, CdTe, ZnS, ZnSe, ZnTe, ZnSeS, ZnTeS, GaAs, GaP, GaSb, HgS, HgSe, HgTe, InAs, InP, InGaP, InSb, AlAs, AlP, and AlSb.

A quantum dot may have a full width at half maximum (FWHM) of a light-emission wavelength spectrum of about 45 nm or less, preferably about 40 nm or less, and more preferably about 30 nm or less. In this range, color purity or color reproducibility may be increased. As the light emitted through such a quantum dot is emitted in all directions, an optical viewing angle may be increased.

A quantum dot may have a shape that is typically used in the art, but is not limited to any particular shape. More specifically, a quantum dot may be, for example, a spherical, pyramidal, multi-arm or cubic-shaped nanoparticle, nanotube, nanowire, nanofiber, or nanoplate particle.

As the first color conversion layer QD1 may be located so as to correspond to the light-emitting area of the first pixel P1, the second color conversion layer QD2 may be located so as to correspond to the light-emitting area of the second pixel P2. As no color conversion layer corresponds to the light-emitting area of the third pixel P3, the transmissive layer TW may be located so as to correspond to the light-emitting area of the third pixel P3. The transmissive layer TW may be formed of an organic material through which the light is emitted without changing or converting the wavelength of the light emitted from the light-emitting element for the third pixel P3 adjacent to the display circuit board S. However, no limitation is intended thereby, and a color conversion layer may be located in the light-emitting area of the third pixel P3.

Particles may be distributed in the first color conversion layer QD1, the second color conversion layer QD2, and the transmissive layer TW. Accordingly, color spreadability may be uniform. In such cases, the particles may include scatterers. For example, the scatterers may include TiO₂.

The light-blocking patterns 810 may be located among the first color conversion layer QD1, the second color conversion layer QD2, and the transmissive layer TW. The light-blocking pattern 810 that is a black matrix may be a member for increasing the color sharpness and contrast. The light-blocking pattern 810 may be located among the light-emitting areas for the first to third pixels P1, P2, and P3. As the light-blocking pattern 810 is a black matrix for absorbing visible light, color mixing of the light emitted from the light-emitting areas of neighboring pixels may be prevented or reduced, and visibility and contrast may be increased.

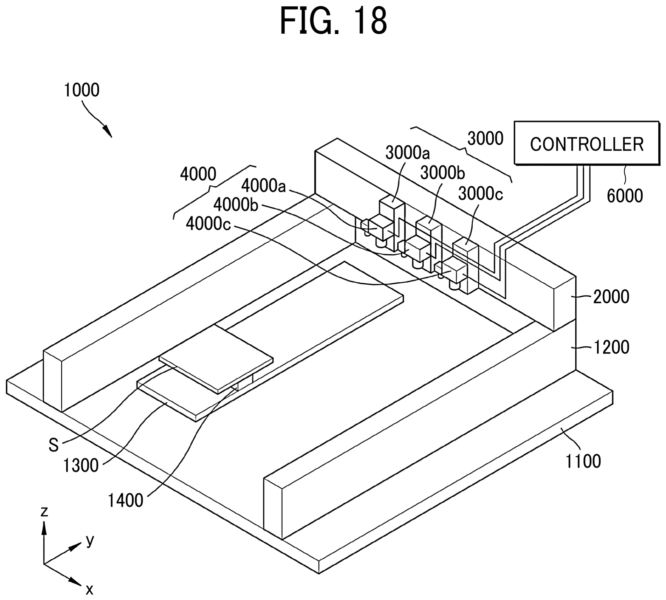

FIG. 18 is a perspective view of a manufacturing apparatus 1000 that manufactures a display device, according to a fourth embodiment.

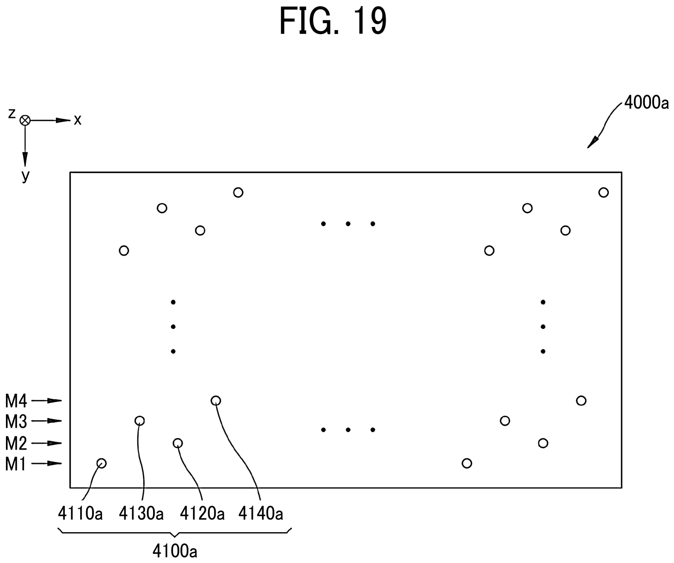

FIG. 19 is a rear view of a first discharge device 4000a according to a fourth embodiment.

The manufacturing apparatus 1000 for display devices is an example of a liquid discharge apparatus.

As illustrated in FIG. 18 and FIG. 19, the manufacturing apparatus 1000 for manufacturing display devices may include a stage 1100, a first gantry 2000, a moving unit 3000, a droplet discharge device 4000, a droplet measurer 5000, and a controller 6000. The liquid discharge head 100 can be applied to the droplet discharge device 4000.

The stage 1100 may include guide units 1200 and a circuit-board moving unit 1300. The stage 1100 may include an alignment mark for aligning the display circuit board S.

The display circuit board S may be a display device to be manufactured, including the substrate 800 and the light-blocking pattern 810 illustrated in FIG. 17. In the display circuit board S provided for the manufacturing apparatus 1000 for manufacturing display devices, the first color conversion layer QD1 and the second color conversion layer QD2 that contain particles are arranged with the light-blocking pattern 810 therebetween.

The right and left guide units 1200 may be separated from each other (e.g., spaced from each other in the X-axis direction of FIG. 18) with the circuit-board moving unit 1300 therebetween. The length of each of the guide units 1200 may be further longer than the length of an edge of the display circuit board S. In such cases, the length of the guide units 1200 and the length of the edge of the display circuit board S may be measured in the Y-axis direction of FIG. 18.

The first gantry 2000 may be located on the guide units 1200. In the present embodiment, the guide units 1200 may include a rail through which the first gantry 2000 moves (e.g., linearly moves) in the longitudinal direction of the guide units 1200. In particular, the guide units 1200 may include a linear motion rail.

The circuit-board moving unit 1300 may be located on the stage 1100, and may include a circuit-board rotating unit 1400. The circuit-board moving unit 1300 may extend in the longitudinal direction of the guide units 1200. For example, referring to FIG. 18, the circuit-board moving unit 1300 may extend in the Y-axis direction. The circuit-board moving unit 1300 may include a rail through which the circuit-board rotating unit 1400 can linearly move. In particular, the circuit-board moving unit 1300 may include a linear motion rail.

The circuit-board rotating unit 1400 may rotate on the circuit-board moving unit 1300. When the circuit-board rotating unit 1400 rotates, the display circuit board S located on the circuit-board rotating unit 1400 may rotate. The circuit-board rotating unit 1400 may rotate about the rotation axis perpendicular to a surface of the stage 1100 on which the display circuit board S is mounted. When the circuit-board rotating unit 1400 rotates about the rotation axis perpendicular to the surface of the stage 1100 on which the display circuit board S is mounted, the display circuit board S located on the circuit-board rotating unit 1400 may also rotate about the rotation axis perpendicular to the surface of the stage 1100 on which the display circuit board S is mounted.

The first gantry 2000 may be located on the guide units 1200. That is, the first gantry 2000 may be located on the guide units 1200 that are spaced from each other with the circuit-board moving unit 1300 therebetween.

The first gantry 2000 may move in the longitudinal direction of the guide units 1200. The first gantry 2000 may be moved linearly in a manual manner, or may be moved linearly in an automatic manner with a motor cylinder or the like. For example, the first gantry 2000 may include a linear motion block moving along a linear motion rail and may linearly move in an automatic manner.

The moving unit 3000 and the droplet discharge device 4000 for discharging a droplet DS may be located on the first gantry 2000. The moving unit 3000 may linearly move on the first gantry 2000. For example, the first gantry 2000 may include a rail through which the moving unit 3000 linearly moves.

The moving unit 3000 may include at least one nozzle moving unit, and at least one discharge device of the droplet discharge device 4000 may be arranged in various suitable ways. In such cases, the moving unit 3000 may linearly move on the first gantry 2000, and the droplet discharge device 4000 may be located on the moving unit 3000 and may supply the droplet DS to the display circuit board S. For example, one nozzle moving unit and one discharge device may be provided. In such cases, the discharge device may include one or more nozzle heads for discharging the droplet DS.

Alternatively, one or more discharge devices may be provided, and one nozzle moving unit may be provided. In such cases, when a plurality of discharge devices are provided, those discharge devices may be located on one nozzle moving unit and may concurrently (e.g., simultaneously) move as the nozzle moving unit moves.

Alternatively, a plurality of nozzle moving units and a plurality of discharge devices may be provided. In such cases, at least one discharge device may be located on one nozzle moving unit. For the sake of explanatory convenience, the following will be described later in detail assuming that one discharge device is located on one nozzle moving unit.

The moving unit 3000 may include a plurality of nozzle moving units. The moving unit 3000 may include a first nozzle moving unit 3000a, a second nozzle moving unit 3000b, and a third nozzle moving unit 3000c. The second nozzle moving unit 3000b may be located between the first nozzle moving unit 3000a and the third nozzle moving unit 3000c. The moving unit 3000 may include at least one nozzle moving unit, or may include four or more nozzle moving units. However, for the sake of explanatory convenience, cases in which the moving unit 3000 includes the first nozzle moving unit 3000a, the second nozzle moving unit 3000b, and the third nozzle moving unit 3000c will be described later in detail.

In the present embodiment, the interval between the first nozzle moving unit 3000a and the second nozzle moving unit 3000b may be the same as an interval between the second nozzle moving unit 3000b and the third nozzle moving unit 3000c. The interval between the first nozzle moving unit 3000a and the second nozzle moving unit 3000b may be different from an interval between the second nozzle moving unit 3000b and the third nozzle moving unit 3000c.

The moving unit 3000 may linearly move on the first gantry 2000. More specifically, the moving unit 3000 may move in the longitudinal direction of the first gantry 2000. For example, at least one of the first nozzle moving unit 3000a, the second nozzle moving unit 3000b, or the third nozzle moving unit 3000c may move in the X-axis direction or the -X-axis direction.

In the present embodiment, the moving unit 3000 may linearly move in a manual manner. The moving unit 3000 may include, for example, a motor cylinder and may linearly move in an automatic manner. For example, the moving unit 3000 may include a linear motion block that moves along a linear motion rail.

A discharge device of the droplet discharge device 4000 may be located on a nozzle moving unit of the moving unit 3000. In such cases, the discharge device of the droplet discharge device 4000 may supply the droplet DS to the display circuit board S. In such cases, the discharge device of the droplet discharge device 4000 may supply various kinds of suitable materials to the display circuit board S. For example, a first discharge device 4000a may be located on the first nozzle moving unit 3000a. As another example, a second discharge device 4000b may be located on the second nozzle moving unit 3000b. As another example, a third discharge device 4000c may be located on the third nozzle moving unit 3000c.

In such cases, at least one of the first discharge device 4000a through the third discharge device 4000c may include at least one ejection hole for discharging the droplet DS. For the sake of explanatory convenience, cases in which each of the first discharge device 4000a through the third discharge device 4000c includes one ejection hole will be described later in detail.

The droplet discharge device 4000 may discharge the droplet DS to the display circuit board S. In such cases, the droplet DS may include a color conversion layer material including particles or a color filter material including particles. Alternatively, the droplet DS may include quantum dots and particles. For the sake of explanatory convenience, cases in which the droplet DS includes particles and quantum dots will be described later in detail.

The amount of the droplet DS discharged from each of the first discharge device 4000a, the second discharge device 4000b, and the third discharge device 4000c may be independently adjusted. In such cases, each of the first discharge device 4000a, the second discharge device 4000b, and the third discharge device 4000c may be electrically connected to the controller 6000. Accordingly, the amount of the droplet DS discharged from each of the first discharge device 4000a, the second discharge device 4000b, and the third discharge device 4000c may be adjusted by the controller 6000.

Each of the first discharge device 4000a through the third discharge device 4000c may supply a droplet to the display circuit board S. In the present embodiment, under the condition that the display circuit board S is fixed, the first discharge device 4000a through the third discharge device 4000c may supply the droplet to the display circuit board S while reciprocating in one direction (e.g., the Y-axis direction of FIG. 18). Also, the first discharge device 4000a through the third discharge device 4000c may move by a certain interval in the longitudinal direction of the first gantry 2000 and then may supply the droplet to another portion of the display circuit board S while moving in the same direction as the above direction (e.g., the Y-axis direction of FIG. 18). The first discharge device 4000a through the third discharge device 4000c may move in the X-axis direction of FIG. 18 on the display circuit board S, and may supply the droplet to the display circuit board S while the display circuit board S moves in the Y-axis direction.

For the sake of explanatory convenience, cases in which the display circuit board S reciprocates in the Y-axis direction of FIG. 18 and the first discharge device 4000a through the third discharge device 4000c supply the droplet to the display circuit board S while moving by a certain interval in the X-axis direction of FIG. 18 will be described later in detail.

Each of the first discharge device 4000a through the third discharge device 4000c may include a nozzle. In such cases, the first discharge device 4000a through the third discharge device 4000c are formed to be the same as or similar to each other, and thus, the first discharge device 4000a will be described later in detail.

The first discharge device 4000a may include at least one first nozzle 4100a. For example, the first discharge device 4000a may include one first nozzle 4100a.

The first discharge device 4000a may include a plurality of first nozzles 4100a. In such cases, those first nozzles 4100a may be spaced from one another, and may be arranged in a zigzag shape. For example, those first nozzles 4100a may include a 1-1st nozzle 4110a located in a first row M1 illustrated in a lower portion of FIG. 19.

Those first nozzles 4100a may include a 1-2nd nozzle 4120a located in a second row M2. Those first nozzles 4100a may include a 1-3rd nozzle 4130a located in a third column M3, and a 1-4th nozzle 4140a located in a fourth column M4. In such cases, the 1-1st nozzle 4110a through the 1-4th nozzle 4140a may make up one nozzle group, and a plurality of nozzle groups may be arranged so as to be spaced from one another in the X-axis direction of FIG. 19.

Those nozzle groups may be located to be spaced from one another in the Y-axis direction of FIG. 19. In such cases, the 1-1st nozzles 4110a of the nozzle groups spaced from one another in the Y-axis direction of FIG. 19 may be arranged obliquely, rather than in a straight line parallel to the Y-axis direction.

In FIG. 19, a group of nozzles are arrayed in an inclined direction toward the X-axis direction by 3 to 25° or 5 to 20° with reference to the Y-axis direction. In such cases, the 1-2nd nozzle 4120a, the 1-3rd nozzle 4130a, and the 1-4th nozzle 4140a of each nozzle group may be arranged obliquely in a similar manner to or in the same manner as that of the 1-1st nozzle 4110a. In other words, nozzles that correspond to each other (e.g., the 1-1st nozzles 4110a) in a series of nozzle groups that are arrayed in a matrix in the X-axis direction and the Y-axis direction may be arrayed in a row in the X-axis direction, but may not be arrayed in a row in the Y-axis direction. Those nozzles may be obliquely arrayed in a row, in a direction between the X-axis direction and the Y-axis direction.

The 1-1st nozzle 4110a through the 1-4th nozzle 4140a of each nozzle group may supply the droplet to different areas of the display circuit board S. At least two of the 1-1st nozzle 4110a through the 1-4th nozzle 4140a of each nozzle group may supply the droplet to the same area of the display circuit board S. At least one of the 1-1st nozzle 4110a through the 1-4th nozzle 4140a of a first nozzle group and at least one of the 1-1st nozzle 4110a through the 1-4th nozzle 4140a of a second nozzle group that is different from the first nozzle group may supply the droplet to the same area of the display circuit board S.

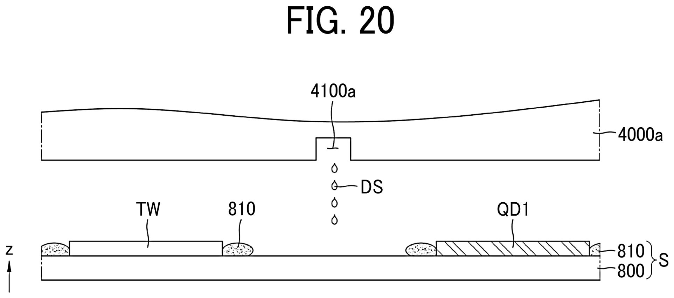

The display circuit board S is located on the stage 1100 of FIG. 18, and then at least one of the first color conversion layer QD1, the second color conversion layer QD2, and the transmissive layer TW may be formed in the opening or space between a pair of the light-blocking patterns 810 that are arranged like a grid. For the sake of explanatory convenience, cases in which patterns of the second color conversion layer QD2 are formed will be described later in detail. Cases in which patterns of the second color conversion layer QD2 are formed through the first nozzle 4100a of the first discharge device 4000a will be described later in detail with reference to FIG. 20.

FIG. 20 is a diagram illustrating a method of manufacturing display devices and the order in which those display devices are manufactured, according to a fourth embodiment. As illustrated in FIG. 20, the display circuit board S may include the upper substrate 800 and the light-blocking patterns 810.

When the droplet DS is supplied from the first nozzle 4100a of the first discharge device 4000a in order to form the second color conversion layer QD2, the controller 6000 may select the first nozzle 4100a that should supply the droplet DS from among those first nozzles 4100a to correspond to a volume of the droplet DS used to form the second color conversion layer QD2 and a concentration of particles to be contained in the second color conversion layer QD2 based on concentrations of particles contained in the droplet DS discharged from those first nozzles 4100a, and may adjust the position of the first discharge device 4000a so that the selected first nozzle 4100a passes through a portion of the display circuit board S on which the second color conversion layer QD2 should be formed.

The controller 6000 may adjust the number of times the droplet DS is discharged through the selected first nozzle 4100a. The controller 6000 may adjust the amount of the droplet DS discharged and supplied at a time through the selected first nozzle 4100a. How the droplet DS is to be controlled as above may be stored as a table in the controller 6000, or may be stored as a formula or the like calculated through a separate program in the controller 6000.

The above process may also be performed in the same manner on the second color conversion layer QD2 located at another position of the display circuit board S. In such cases, the above process may be performed in the same manner on the first color conversion layer QD1 and the transmissive layer TW, in addition to the second color conversion layer QD2.

As illustrated in FIG. 16, the display circuit board S, which is manufactured through the above-described processes, is bonded to the backplane circuit board 820, on which the TFT layer 81 and the light-emitting layers LED1 to LED3 are formed, through the intermediate layer 822. This makes up the OLED panel DP. Further, by coupling the controller 823 to the OLED panel DP, the display device DA with the display circuit board S can be obtained as above.

As described above, the liquid discharge head 100 provided with the drive waveform generator or the liquid discharge apparatus is applied to the manufacturing apparatus 1000 for manufacturing the display circuit board S. Due to such a configuration, a reduction in the discharge speed of the second drop due to the transient response to the residual vibration of the first drop can be prevented, and a displacement in the landing position of the second drop can be prevented. Moreover, the first color conversion layer QD1 and the second color conversion layer QD2 can be formed evenly, and the brightness or density on the display device DA with the display circuit board S can be made even.

Aspects of the present disclosure are, for example, as follows.

### First Aspect

A drive waveform generator includes a drive waveform generation unit to generate a drive waveform including a plurality of driving pulses to be applied to a liquid discharge head. The plurality of driving pulses include a discharge pulse to cause a liquid to be discharged, for liquid discharge of a first drop, and a combination of the discharge pulse and an excitation pulse not to cause the liquid to be discharged before the discharge pulse, for liquid discharge of a second drop. A landing position of the second drop is different from a landing position of the first drop.

### Second Aspect

In the drive waveform generator according to the first aspect, an interval between the excitation pulse for the second drop and the discharge pulse for the second drop is in a resonant relation where pressing force of the discharge pulse for the second drop is amplified due to residual vibration caused by the excitation pulse for the second drop.

### Third Aspect

In the drive waveform generator according to the first aspect or the second aspect, a time interval between the excitation pulse for the second drop and the discharge pulse for the second drop falls within a range of N×Tc±(1/4)Tc, where N denotes a natural number and Tc denotes a resonance cycle of the liquid discharge head.

### Fourth Aspect

In the drive waveform generator according to the first aspect or the second aspect, a time interval between the excitation pulse for the second drop and the discharge pulse for the second drop falls within a range of N×Tc±(1/8)Tc and N denotes a natural number and Tc denotes a resonance cycle of the liquid discharge head.

### Fifth Aspect

In the drive waveform generator according to the first aspect or the second aspect, a time difference between an instant when a voltage of the excitation pulse to apply pressure to the second drop changes and an instant when a voltage of the discharge pulse to apply pressure to the second drop changes falls within a range of N×Tc±(1/4)Tc, where N denotes a natural number and Tc denotes a resonance cycle of the liquid discharge head.

### Sixth Aspect

In the drive waveform generator according to the first aspect or the second aspect, a time difference between an instant when a voltage of the excitation pulse to apply pressure to the second drop changes and an instant when a voltage of the discharge pulse to apply pressure to the second drop changes falls within a range of N×Tc±(1/8)Tc, where N denotes a natural number and Tc denotes a resonance cycle of the liquid discharge head.

### Seventh Aspect

In the drive waveform generator according to any one of the first aspect to the sixth aspect, when the liquid discharge head is continuously driven to discharge three or more drops of the liquid with the discharge pulse, the plurality of driving pulses include a combination of the discharge pulse and the excitation pulse added before the discharge pulse, for liquid discharge of a third drop and following drops.

### Eighth Aspect

In the drive waveform generator according to any one of the first aspect to the seventh aspect, the excitation pulse is used alone as a microdrive pulse of microdrive waveform to vibrate a meniscus to a degree that the liquid is not discharged in a non-printing area.

### Ninth Aspect

In the drive waveform generator according to any one of the first aspect to the eighth aspect, the drive waveform is not applied to a high-resolution mode where the liquid discharge head is driven at a low frequency, and the drive waveform is applied to a high-productivity mode where the liquid discharge head is driven at a high frequency.

### Tenth Aspect

In the drive waveform generator according to the first aspect, the discharge pulse to cause the liquid to be discharged as one of the plurality of driving pulses for the liquid discharge of the first drop has a waveform equivalent to that of the discharge pulse to cause the liquid to be discharged as another one of the plurality of driving pulses for the liquid discharge of the second drop.

### Eleventh Aspect

A liquid discharge head includes the drive waveform generator according to any one of the first aspect to the tenth aspect

### Twelfth Aspect

A liquid discharge apparatus includes a liquid discharge head, and the drive waveform generator according to any one of the first aspect to the tenth aspect.

### Thirteenth Aspect

A manufacturing apparatus for a display device is provided, and the manufacturing apparatus includes a liquid discharge head, and the drive waveform generator according to any one of the first aspect to the tenth aspect.

### Fourteenth Aspect

A method of manufacturing a display device with a color conversion layer, which includes forming the color conversion layer by a liquid discharged from a liquid discharge head, and applying a drive waveform including a plurality of driving pulses generated by a drive waveform generation unit to the liquid discharge head. The plurality of driving pulses includes: a discharge pulse to cause a liquid to be discharged, for liquid discharge of a first drop; and a combination of the discharge pulse and an excitation pulse not to cause the liquid to be discharged before the discharge pulse, for liquid discharge of a second drop. A landing position of the second drop is different from a landing position of the first drop.

Any one of the above-described operations may be performed in various other ways, for example, in an order different from the one described above.

The present invention can be implemented in any convenient form, for example using dedicated hardware, or a mixture of dedicated hardware and software. The present invention may be implemented as computer software implemented by one or more networked processing apparatuses.

The processing apparatuses include any suitably programmed apparatuses such as a general purpose computer, a personal digital assistant, a Wireless Application Protocol (WAP) or third-generation (3G)-compliant mobile telephone, and so on. Since the present invention can be implemented as software, each and every aspect of the present invention thus encompasses computer software implementable on a programmable device. The computer software can be provided to the programmable device using any conventional carrier medium (carrier means). The carrier medium includes a transient carrier medium such as an electrical, optical, microwave, acoustic or radio frequency signal carrying the computer code. An example of such a transient medium is a Transmission Control Protocol/Internet Protocol (TCP/IP) signal carrying computer code over an IP network, such as the Internet. The carrier medium may also include a storage medium for storing processor readable code such as a floppy disk, a hard disk, a compact disc read-only memory (CD-ROM), a magnetic tape device, or a solid state memory device.

## Claims

1. A drive waveform generator (400) comprising
a drive waveform generation unit (402, 403) configured to generate a drive waveform (Va) including a plurality of driving pulses to be applied to a liquid discharge head (100),
the plurality of driving pulses including:
a discharge pulse (P1) to cause a liquid to be discharged, for liquid discharge of a first drop; and
a combination of the discharge pulse (P1) and an excitation pulse (P2) not to cause the liquid to be discharged before the discharge pulse (P1), for liquid discharge of a second drop,
a landing position of the second drop being different from a landing position of the first drop.

2. The drive waveform generator (400) according to claim 1,
wherein an interval between the excitation pulse (P2) for the second drop and the discharge pulse (P1) for the second drop is in a resonant relation where pressing force of the discharge pulse (P1) for the second drop is amplified due to residual vibration caused by the excitation pulse (P2) for the second drop.

3. The drive waveform generator (400) according to claim 1 or 2,
wherein a time interval between the excitation pulse (P2) for the second drop and the discharge pulse (P1) for the second drop falls within a range of N×Tc±(1/4)Tc, where N denotes a natural number and Tc denotes a resonance cycle of the liquid discharge head (100).

4. The drive waveform generator (400) according to claim 1 or 2,
wherein a time interval between the excitation pulse (P2) for the second drop and the discharge pulse (P1) for the second drop falls within a range of N×Tc±(1/8)Tc, where N denotes a natural number and Tc denotes a resonance cycle of the liquid discharge head (100).

5. The drive waveform generator (400) according to claim 1 or 2,
wherein a time difference between an instant when a voltage of the excitation pulse (P2) to apply pressure to the second drop changes and an instant when a voltage of the discharge pulse (P1) to apply pressure to the second drop changes falls within a range of N×Tc±(1/4)Tc, where N denotes a natural number and Tc denotes a resonance cycle of the liquid discharge head (100).

6. The drive waveform generator (400) according to claim 1 or 2,
wherein a time difference between an instant when a voltage of the excitation pulse (P2) to apply pressure to the second drop changes and an instant when a voltage of the discharge pulse (P1) to apply pressure to the second drop changes falls within a range of N×Tc±(1/8)Tc, where N denotes a natural number and Tc denotes a resonance cycle of the liquid discharge head (100).

7. The drive waveform generator (400) according to any one of claims 1 to 6,
wherein when the liquid discharge head (100) is continuously driven to discharge three or more drops of the liquid with the discharge pulse (P1), the plurality of driving pulses include a combination of the discharge pulse (P1) and the excitation pulse (P2) added before the discharge pulse (P1), for liquid discharge of a third drop and following drops.

8. The drive waveform generator (400) according to any one of claims 1 to 7,
wherein the excitation pulse (P2) is used alone as a microdrive pulse of microdrive waveform to vibrate a meniscus to a degree that the liquid is not discharged in a non-printing area.

9. The drive waveform generator (400) according to any one of claims 1 to 8,
wherein the drive waveform (Va) is not applied to a high-resolution mode where the liquid discharge head (100) is driven at a low frequency, and
wherein the drive waveform (Va) is applied to a high-productivity mode where the liquid discharge head (100) is driven at a high frequency.

10. The drive waveform generator (400) according to claim 1,
wherein the discharge pulse (P1) to cause the liquid to be discharged as one of the plurality of driving pulses for the liquid discharge of the first drop has a waveform equivalent to that of the discharge pulse (P1) to cause the liquid to be discharged as another one of the plurality of driving pulses for the liquid discharge of the second drop.

11. A liquid discharge head (100) comprising
the drive waveform generator (400) according to any one of claims 1 to 10.

12. A liquid discharge apparatus (1) comprising:
a liquid discharge head (100); and
the drive waveform generator (400) according to any one of claims 1 to 10.

13. A manufacturing apparatus (1000) for a display device (DA), the manufacturing apparatus comprising:
a liquid discharge head (100); and
the drive waveform generator (400) according to any one of claims 1 to 10.

14. A method of manufacturing a display device (DA) with a color conversion layer (QD1, QD2), the method comprising:
forming the color conversion layer (QD1, QD2) by a liquid discharged from a liquid discharge head (100); and
applying a drive waveform (Va) including a plurality of driving pulses to the liquid discharge head (100),
the plurality of driving pulses including:
a discharge pulse (P1) to cause a liquid to be discharged, for liquid discharge of a first drop; and
a combination of the discharge pulse (P1) and an excitation pulse (P2) not to cause the liquid to be discharged before the discharge pulse (P1), for liquid discharge of a second drop,
a landing position of the second drop being different from a landing position of the first drop.
